# EUROPEAN PATENT SPECIFICATION

(11) **EP 3 327 793 B1**
(45) Date of publication and mention of the grant of the patent: **07.06.2023**
(21) Application number: 17203032.2
(22) Date of filing: 22.11.2017
(51) Int. Cl.: H01L 31/0224, H01L 31/0747, H01L 31/0368, H01L 31/18

(54) **SOLAR CELL AND METHOD OF MANUFACTURING THE SAME**
SOLARZELLE UND VERFAHREN ZUR HERSTELLUNG DAVON
CELLULE SOLAIRE ET SON PROCÉDÉ DE FABRICATION

(30) Priority: 23.11.2016 KR 20160156790
(43) Date of publication of application: 30.05.2018
(73) Proprietor: Shangrao Jinko solar Technology Development Co., LTD, JIANGXI PROVINCE (CN)
(72) Inventor: HA, Jungmin, 08592 Seoul (KR); CHO, Sungyeon, 08592 Seoul (KR); PARK, Sangwook, 08592 Seoul (KR)
(74) Representative: DREISS Patentanwälte PartG mbB

(56) References cited:
- EP-A1- 3 026 713
- CN-A- 105 990 465
- JP-A- H09 181 347
- JP-A- 2008 060 205
- JP-A- 2014 232 821
- US-A1- 2014 352 770

## Description

### CROSS-REFERENCE TO RELATED APPLICATION

### TECHNICAL FIELD

The present disclosure relates to a method of manufacturing the same, and more particularly, to a method of manufacturing a solar cell having an improved structure.

### BACKGROUND

Recently, due to depletion of existing energy resources, such as oil and coal, interest in alternative sources of energy to replace the existing energy resources is increasing. Most of all, solar cells are popular next generation cells to convert sunlight into electrical energy.

Solar cells may be manufactured by forming various layers and electrodes based on some design. The efficiency of solar cells may be determined by the design of the various layers and electrodes. In order for solar cells to be commercialized, it is necessary to overcome the low efficiency thereof. Therefore, there is a need to maximize the efficiency of solar cells.

Meanwhile, a method of manufacturing a solar cell includes a process of dividing a semiconductor substrate. In this semiconductor substrate dividing process, a laser may be used to divide the semiconductor substrate. However, the dividing process using the laser may cause deterioration in the solar cell due to the laser.

From EP 3 026 713 A1 a solar cell and a method for manufacturing the same is known in which an isolation portion is formed at the edge of the back surface of the solar cell by providing a mask layer and subsequent etching of the regions that are not covered by the mask layer. In the isolation portion, a tunnel layer and a semiconductor region are not provided.

From CN 105 990 456 A a further solar cell and a manufacturing method for the same is known in which first and second masks are formed on first and second transparent conductive layers on the first and second surfaces of the silicon semiconductor substrate. Subsequently, the first and second transparent conductive layers at the side wall surface of the semiconductor substrate are removed through an etching gas.

Likewise, from JP 2014 232821 A a solar cell and a manufacturing method therefor are known in which an insulating region is formed on a first principal side and side face of the solar cell by laser irradiation.

JP H09-181347 A discloses a solar cell with a single crystal silicon substrate having a front surface and a rear surface. The arrangement of the layers provided on the substrate is identical on the front surface and back surface of the substrate. On particular, on both the front surface and the rear surface, an i-type first amorphous silicon layer is provided extending over the whole front and rear surfaces, respectively, and a second doped amorphous silicon layer is provided on the respective first amorphous silicon layer, wherein each of the second amorphous silicon layers is formed not to extend over the whole front and rear surfaces.

JP 2008 060205 A discloses a method of forming a solar cell in which a dividing groove is formed in a surface opposite to the light receiving surface by laser processing. After having formed the dividing groove, the solar cell is cut along a cutting region by bending and breaking at the portion of the dividing groove.

US 5 401 336 A discloses a method of fabricating a photovoltaic device comprising steps of providing a pattern resist as a mask on a crystalline silicon substrate, forming semiconductor layers on the resist and the substrate and lifting off the resist except at the portions where the semiconductor layers are formed on the crystalline silicon substrate.

### SUMMARY

According to an aspect of the present disclosure, there is provided a method of manufacturing a solar cell, the method comprising the features of the independent method claim 1.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a cross-sectional view illustrating a solar cell manufactured according to a method of the present disclosure;
FIGS. 2 to 11 are cross-sectional views and plain views for explaining a method of manufacturing the solar cell according to some implementations of the present disclosure;
FIG. 12 is a cross-sectional view illustrating a solar cell manufactured according to some implementations of the present disclosure;
FIGS. 13 to 18 are cross-sectional views and plain views for explaining a method of manufacturing the solar cell according to some implementations of the present disclosure;
FIG. 19 is a cross-sectional view illustrating a solar cell manufactured according to some implementations of the present disclosure;
FIGS. 20 to 23 are cross-sectional views and plain views for explaining a method of manufacturing the solar cell according to some implementations of the present disclosure; and
FIG. 24 is a cross-sectional view illustrating a solar cell manufactured according to some implementations of the present disclosure

### DETAILED DESCRIPTION

Reference will now be made in detail to the implementations of the present disclosure, examples of which are illustrated in the accompanying drawings.

In the drawings, to clearly and briefly explain the present disclosure, illustration of elements having no connection with the description is omitted, and the same or extremely similar elements are designated by the same reference numerals throughout the specification. In addition, in the drawings, for more clear explanation, the thickness, the width, and the like are exaggerated or reduced, and the thickness, width, and the like of the present disclosure are not limited to the illustration of the drawings.

In addition, in the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

Hereinafter, a solar cell according to some implementations of the present disclosure will be described in detail with reference to the accompanying drawings.

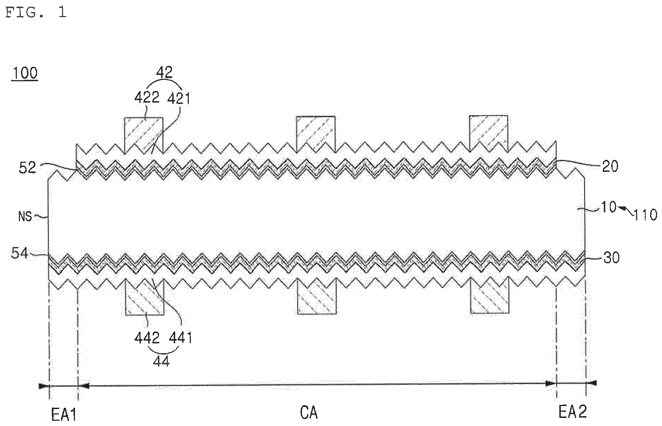

FIG. 1 is a cross-sectional view illustrating a solar cell according to some implementations of the present disclosure.

Referring to FIG. 1, the solar cell 100 according to the present implementation may include a semiconductor substrate 110 including a base area 10, a first passivation layer 52 formed on a first surface of the semiconductor substrate 110, a second passivation layer 54 formed on a second surface of the semiconductor substrate 110, a first conductive area 20 formed on the first passivation layer 52 at the first surface side of the semiconductor substrate 110, a second conductive area 30 formed on the second passivation layer 54 at the second surface side of the semiconductor substrate 110, a first electrode 42 electrically connected to the first conductive area 20, and a second electrode 44 electrically connected to the second conductive area 30. Although the first surface and the second surface may be opposite each other, and the first surface may be a light incidence surface of the solar cell 100, the technical feature of the present disclosure is not limited thereto.

In the present implementation, each of the first surface and the second surface of the semiconductor substrate 110 includes first and second edge areas EA1 and EA2, and a cell area CA between the first and second edge areas EA1 and EA2. Each of the first and second edge areas EA1 and EA2 may be the area that is adjacent to a side surface NS, which connects the first surface and the second surface of the semiconductor substrate 110 to each other.

In the present implementation, the first and second edge areas EA1 and EA2 of the first surface of the semiconductor substrate 110 may be the area in which no conductive area or no passivation layer is disposed, and the cell area CA of the first surface of the semiconductor substrate 110 may be the area in which a semiconductor layer such as the passivation layer is disposed. Thus, in the present implementation, the semiconductor substrate 110 may be exposed through the first and second edge areas EA1 and EA2 of the first surface. In addition, the first and second edge areas EA1 and EA2 of the semiconductor substrate 110 may have the same doping concentration in the depth direction, and the crystalline structure of the semiconductor substrate 110 may differ between the first and second edge areas EA1 and EA2 of the first surface and the first and second edge areas EA1 and EA2 of the second surface. A more detailed description related thereto will be provided later.

The semiconductor substrate 110 may be formed of crystalline semiconductors. In one example forming background art, the semiconductor substrate 110 may be formed of monocrystalline or polycrystalline semiconductors (e.g., monocrystalline or polycrystalline silicon). In particular, in the present implementation, the semiconductor substrate 110 is formed of monocrystalline semiconductors (i.e., a monocrystalline semiconductor wafer, and more specifically, a monocrystalline silicon wafer). Since the semiconductor substrate 110 is formed of monocrystalline semiconductors (e.g., monocrystalline silicon), the solar cell 100 configures a monocrystalline semiconductor solar cell (e.g., a monocrystalline silicon solar cell). Such a solar cell 100 may have excellent electrical properties because it is based on the semiconductor substrate 110 having high crystallinity and thus low defects.

In the present implementation, the semiconductor substrate 110 may include only the base area 10 without including a separate doped area. When the semiconductor substrate 110 includes no doped area, for example, damage to the semiconductor substrate 110 or an increase in the number of defects, which may occur when forming a doped area, may be prevented, whereby the semiconductor substrate 110 may have an excellent passivation property. Thereby, surface recombination, which may occur in the surface of the semiconductor substrate 110, may be minimized.

In the present implementation, the semiconductor substrate 110 or the base area 10 may be doped with a first conductive dopant, which is a base dopant, at a low doping concentration, thus being of a first conductive type. At this time, the semiconductor substrate 110 or the base area 10 may have a lower doping concentration, higher resistance, or lower carrier concentration than the first conductive area 20, which is of the same conductive type as the semiconductor substrate 110 or the base area 10.

The first surface and/or the second surface of the semiconductor substrate 110 may be subjected to texturing in order to prevent reflection. Thereby, both the first surface and the second surface of the semiconductor substrate 110 may prevent the reflection of light introduced thereinto. Therefore, the solar cell 100 of the present implementation having a bi-facial structure may effectively reduce shading loss. However, the present disclosure is not limited thereto, and only one of the first surface and the second surface of the semiconductor substrate 110 may be subjected to texturing.

As described above, each of the first surface and the second surface of the semiconductor substrate 110 includes the first and second edge areas EA1 and EA2, and the cell area CA between the first and second edge areas EA1 and EA2. The first and second edge areas EA1 and EA2 of the first surface of the semiconductor substrate 110 may be exposed, thus including a damaged area. The damaged area is caused by laser irradiation. In some implementations, the first and second edge areas EA1 and EA2 included in the first surface of the semiconductor substrate 110 may be coupled to each other when viewing the solar cell 100 in a plain view. In some other implementations, the first and second edge areas EA1 and EA2 included in the second surface of the semiconductor substrate 110 may be coupled to each other when viewing the solar cell 100 in a plain view.

In addition, the first and second edge areas EA1 and EA2 of the first surface of the semiconductor substrate 110 and the first and second edge areas EA1 and EA2 of the second surface may have different crystalline structures. Specifically, the crystalline structure of the first and second edge areas EA1 and EA2 of the first surface of the semiconductor substrate 110 may be larger than the crystalline structure of the first and second edge areas EA1 and EA2 of the second surface. This may be realized via laser irradiation for wafer scribing. That is, when attempting laser scribing through the first surface of the semiconductor substrate 110, the first and second edge areas EA1 and EA2 of the first surface may have a damaged area due to laser irradiation, and the crystalline structure in the damaged area may become larger than the crystalline structure of the first and second edge areas EA1 and EA2 of the second surface.

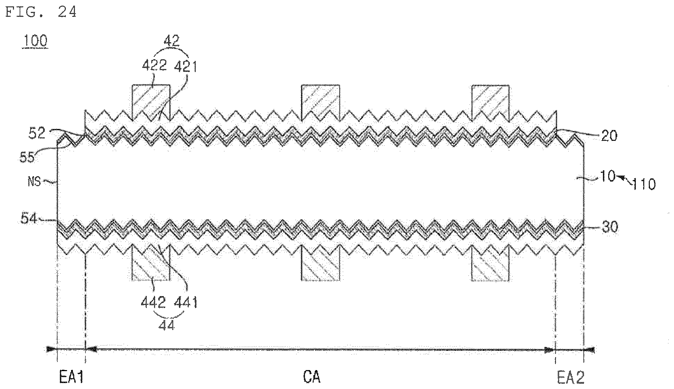

FIG. 24 is a cross-sectional view illustrating a solar cell according to some implementations of the present disclosure

Furthermore, referring FIG 24, an oxide(55) may be formed on the exposed first and second edge area (EA1 and ES2). Also The oxide(55) may be a silicon oxide

Meanwhile, in the present disclosure, the first and second edge areas EA1 and EA2 of the first surface of the semiconductor substrate 110 may have a consistent doping concentration in the depth direction thereof. This is a structural feature derived from the method of manufacturing the present disclosure, and will be described later in more detail with relation to the manufacturing method, which will be described later.

The first passivation layer 52 is formed on the first surface of the semiconductor substrate 10, and the second passivation layer 54 is formed on the second surface of the semiconductor substrate 10. Thereby, each of the first surface and the second surface of the semiconductor substrate may be passivated.

In the present implementation, the first passivation layer 52 may not be formed in the first and second edge areas EA1 and EA2 on the first surface of the semiconductor substrate 110.

In another implementation of the present disclosure, the first passivation layer 52 may extend to the first and second edge areas EA1 and EA2 of the first surface so as to cover the first and second edge areas EA1 and EA2 on the first surface. A more detailed description will be provided later.

In this specification, although the terms "the first passivation layer 52" and "the second passivation layer 54" are used, the first passivation layer 52 and the second passivation layer 54 may also serve as tunneling layers. That is, the first and second passivation layers 52 and 54 may serve as a barrier for electrons and holes so as to prevent minority carriers from passing therethrough, and to allow only majority carriers, which accumulate at a portion adjacent to the first and second passivation layers 52 and 54 and thus have a given amount of energy or more, to pass therethrough. In one example, the first and second passivation layers 52 and 54 may include intrinsic amorphous semiconductors. For example, the first and second passivation layers 52 and 54 may be formed as intrinsic amorphous silicon (i-a-si) layers. As such, since the first and second passivation layers 52 and 54 include the same semiconductor material as the semiconductor substrate 110 and have properties similar to those of the semiconductor substrate 110, the surface properties of the semiconductor substrate 110 may be more effectively improved. Thereby, the passivation property thereof may be greatly improved. However, the present disclosure is not limited thereto. Thus, the first and/or second passivation layers 52 and 54 may include an intrinsic amorphous silicon carbide (i-a-SiCx) layer or an intrinsic amorphous silicon oxide (i-a-SiOx) layer.

At this time, the first and second passivation layers 52 and 54 may be formed respectively throughout the first surface and the second surface of the semiconductor substrate 110. Thereby, the first surface and the second surface of the semiconductor substrate 110 may be wholly passivated, and may be easily formed without separate patterning. Each of the first and second passivation layers 52 and 54 may have a thickness ranging from 2 nm to 8 nm.

The first conductive area 20 of a first conductive type is formed on the first passivation layer 52. The second conductive area 30 of a second conductive type, which is the opposite of the first conductive type, is formed on the second passivation layer 54.

In the present disclosure, the first conductive area 20 is not formed in the first and second edge areas EA1 and EA2 on the first surface of the semiconductor substrate 110, but is formed in the cell area CA on the first surface. Unlike this, the second conductive area 30 is formed in all of the first and second edge areas EA1 and EA2 and the cell area CA on the second surface of the semiconductor substrate 110

The first conductive area 20 may be a first conductive area including a first conductive dopant. In addition, the second conductive area 30 may be a second conductive area including a second conductive dopant. In one example, the first conductive area 20 may come into contact with the first passivation layer 52, and the second conductive area 30 may come into contact with the second passivation layer 54. As such, the structure of the solar cell 100 may be simplified, and the tunneling effect of the first and second passivation layers 52 and 54 may be maximized. However, the present disclosure is not limited thereto.

Since the first conductive area 20 and the second conductive area 30 are formed on the semiconductor substrate 160 separately from the semiconductor substrate 160, the first conductive area 20 and the second conductive area 30 may have a different material and have a different crystalline structure from that of the semiconductor substrate 110, in order to be easily formed on the semiconductor substrate 110.

For example, each of the first conductive area 20 and the second conductive area 30 may be formed by doping, for example, an amorphous semiconductor layer, which may be easily manufactured via any of various methods, such as, for example, deposition, with a first or second conductive dopant. As such, the first conductive area 20 and the second conductive area 30 may be easily formed via a simplified process. At this time, when the first and second passivation layers 52 and 54 are formed of intrinsic semiconductor substrate (e.g., intrinsic amorphous silicon) as described above, for example, excellent adhesion and excellent electrical conductivity may be acquired.

In addition, a p-type dopant, used as the first or second conductive dopant, may be a group-III element, such as boron (B), aluminum (Al), gallium (ga), or indium (In), and an n-type dopant may be a group-V element, such as phosphorus (P), arsenic (As), bismuth (Bi), or antimony (Sb). However, the present disclosure is not limited thereto, and various other dopants may be used as the first or second conductive dopant.

In one example, the semiconductor substrate 110 and the first conductive area 20, which are of the first conductive type, may be of an n-type, and the second conductive area 30 may be of a p-type. Thereby, the n-type semiconductor substrate 110 may provide an excellent carrier lifetime. In this case, the semiconductor substrate 110 and the first conductive area 20 may include phosphorus (P) as the n-type dopant, and the second conductive area 30 may include boron (B) as the p-type dopant. However, the present disclosure is not limited thereto, and the semiconductor substrate 110 and the first conductive area 20 of the first conductive type may be of a p-type and the second conductive area 30 may be of an n-type.

In the present implementation, each of the first conductive area 20 and the second conductive area 30 includes an amorphous silicon (a-Si) layer, and may include at least one of an amorphous silicon oxide (a-SiOx) layer and an amorphous silicon carbide (a-SiCx) layer.

At this time, the amorphous silicon (a-Si) layer, the amorphous silicon oxide (a-SiOx) layer, or the amorphous silicon carbide (a-SiCx) layer, which is applied to the first conductive area 20 or the second conductive area 30, may be doped with the first or second conductive dopant.

Among these, the amorphous silicon oxide (a-SiOx) layer and the amorphous silicon carbide (a-SiCx) layer may have a high energy band gap to ensure sufficient energy band bending, thereby being capable of selectively passing carriers.

In addition, the second conductive area 30 includes an amorphous silicon (a-Si) layer, and may include at least one of an amorphous silicon oxide (a-SiOx) layer and an amorphous silicon carbide (a-SiCx) layer. Since the second conductive area 30 may form, along with the semiconductor substrate 110, a p-n junction to participate in photoelectric conversion. In some implementations, the second conductive area 30 and the semiconductor substrate 110 can form a pin junction with the second passivation layer 54 interposed between the second conductive area 30 and the semiconductor substrate 110 to participate in photoelectric conversion. The second conductive area 30 includes the same semiconductor material (i.e., silicon) as the semiconductor substrate 110 so as to have properties similar to those of the semiconductor substrate 110, thereby ensuring the more effective movement of carriers.

Meanwhile, in an example forming background art the first conductive area 20 or the second conductive area 30 may be formed of a metal compound, for example, a metal oxide layer.

In one example, the metal oxide layer, which may be used as the first conductive area 30, may be at least one of a molybdenum oxide layer formed of a molybdenum oxide, a tungsten oxide layer formed of a tungsten oxide (e.g., WO₃), a vanadium oxide layer formed of a vanadium oxide (e.g., V₂Oₓ), a titanium oxide layer formed of a titanium oxide (e.g., TiO₂), a nickel oxide layer formed of a nickel oxide (e.g., NiO), a copper oxide layer formed of a copper oxide (CuO), a rhenium oxide layer formed of a rhenium oxide (e.g., ReO₃), a tantalum oxide layer formed of a tantalum oxide (e.g., TaOₓ), and a hafnium oxide layer formed of a hafnium oxide (e.g., HfO₂).

In particular, when the first conductive area 30 includes a molybdenum oxide layer or a tungsten oxide layer, the first conductive area 30 may exhibit the excellent effect of selectively collecting holes. Meanwhile, the metal compound layer, which may be used as the second conductive area 30, may be a metal oxide layer including at least one of a titanium oxide layer formed of a titanium oxide (e.g., TiO₂), a zinc oxide layer formed of a zinc oxide (e.g., ZnO), a tin oxide layer formed of a tin oxide (e.g., SnO₂), and a zirconium oxide layer formed of a zirconium oxide (e.g., ZrO).

In particular, when the second conductive area 30 includes a titanium oxide layer, the second conductive area 34 may exhibit the excellent effect of selectively collecting electrons.

However, the metal oxide included in the first conductive area 30 or the second conductive area 30 is not limited to the aforementioned metal oxides. The first conductive area 20 may include the aforementioned metal oxide included in the second conductive area 30, and the second conductive area 30 may include the aforementioned metal oxide included in the first conductive area 20.

Each of the first and second conductive areas 20 and 30 may have a thickness ranging from 5 nm to 15 nm.

The first electrode 42 may be disposed on (e.g., in contact with) the first conductive area 20 so as to be electrically connected thereto, and the second electrode 44 may be disposed on (e.g., in contact with) the second conductive area 30 so as to be electrically connected thereto.

The first electrode 42 includes a first transparent electrode layer 421 and a first metal electrode layer 422, which are sequentially stacked one above another on the first conductive area 20.

Here, the first transparent electrode layer 421 may be formed over (e.g., in contact with) the entire first conductive area 20. The term "entire" includes not only the case where the entire first conductive area 20 is covered without leaving an empty space or an empty area, but also the case where a portion of the first conductive area 20 is inevitably excluded. When the first transparent electrode layer 421 is formed over the entire first conductive area 20, carriers may easily reach the first metal electrode layer 422 by passing through the first transparent electrode layer 421, which may result in reduced resistance in the horizontal direction. Because the first conductive area 20, which is configured as an amorphous semiconductor layer, may have relatively low crystallinity, and thus may reduce the mobility of carriers, the provision of the first transparent electrode layer 421 may reduce resistance when carriers move in the horizontal direction.

Because the first transparent electrode layer 421 is formed over the entire first conductive area 20, the first transparent electrode layer 421 may be formed of a material capable of transmitting light (i.e. a light-transmitting material). That is, the first transparent electrode layer 421 may be formed of a transparent conductive material to enable the transmission of light and the easy movement of carriers. Thereby, even when the first transparent electrode layer 421 is formed on the entire first conductive area 20, the transmission of light may not be blocked.

In one example, the first transparent electrode layer 421 may include at least one of indium tin oxide (ITO), aluminum zinc oxide (AZO), boron zinc oxide (BZO), indium tungsten oxide (IWO), and indium cesium oxide (ICO). However, the present disclosure is not limited thereto, and the first transparent electrode layer 421 may include any of various other materials.

At this time, the first transparent electrode layer 421 of the present implementation may include any of the aforementioned materials, which is a main material, and may further include hydrogen. That is, the first transparent electrode layer 421 may include at least one of indium tin oxide including hydrogen (ITO:H), aluminum zinc oxide including hydrogen (AZO:H), boron zinc oxide including hydrogen (BZO:H), indium tungsten oxide including hydrogen (IWO:H), and indium cesium oxide including hydrogen (ICO:H).

The first transparent electrode layer 421 may be formed by deposition. When hydrogen gas is introduced during deposition, the first transparent electrode layer 421 may include hydrogen. When the first transparent electrode layer 421 includes hydrogen, the mobility of electrons or holes may be improved, and the transmittance of light may be improved.

In the present implementation, the first metal electrode layer 422 having a pattern is formed on the first transparent electrode layer 421. In one example, the first metal electrode layer 422 may be in contact with the first transparent electrode layer 421 so as to simplify the structure of the first electrode 42. However, the present disclosure is not limited thereto, and various modifications, such as, for example, a modification in which a separate layer is present between the first metal electrode layer 422 and the first transparent electrode layer 421, are possible.

The first metal electrode layer 422 disposed on the first transparent electrode layer 421 may be formed of a material having higher electrical conductivity than the first transparent electrode layer 421. Thereby, the first metal electrode layer 422 may achieve, for example, an increased carrier collection efficiency and a reduced resistance. In one example, the first metal electrode layer 422 may be formed of a metal that has excellent electrical conductivity and is opaque or has a lower transparency than the first transparent electrode layer 421.

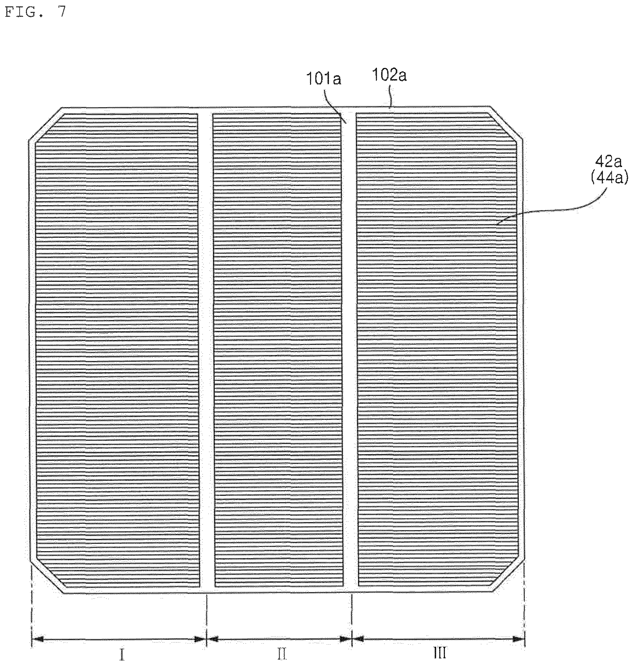

Since the first metal electrode layer 422 may be opaque or have low transparency, and thus may prevent the introduction of light, the first metal electrode layer 422 may have a given pattern in order to minimize shading loss. Thereby, light may be introduced into the portion in which no metal electrode layer 422 is formed. The plan shape of the first metal electrode layer 422 will be described later in more detail with reference to FIG. 7.

The second electrode 44 includes a second transparent electrode layer 441 and a second metal electrode layer 442, which are sequentially stacked one above another on the second conductive area 30. Except for that the second electrode 44 is disposed on the second conductive area 30, for example, the role, material, and shape of the second transparent electrode layer 441 and the second metal electrode layer 442 may be the same as the role, material, and shape of the first transparent electrode layer 421 and the first metal electrode layer 422, and thus the description related to the first transparent electrode layer 421 and the first metal electrode layer 422 may be equally applied to the second transparent electrode layer 441 and the second metal electrode layer 442.

In the present implementation, the metal electrode layers 422 and 442 of the first and second electrodes 42 and 44 may include a conductive material and a resin (e.g., a binder, a curing agent, or an additive). The conductive material may include, for example, silver (Ag), aluminum (Al), or copper (Cu), and the resin may include, for example, a cellulose-based or phenolic-based binder, or an amine-based curing agent.

In addition, when low-temperature firing (e.g., firing at a processing temperature of 300°C or less) is required, glass frit may not be included. Meanwhile, the first and second metal electrode layers 422 and 442 may be formed by plating.

In the present implementation, the first and second edge areas EA1 and EA2 on the first surface of the semiconductor substrate 110 may be exposed because no semiconductor layer is formed thereon. The first and second edge areas EA1 and EA2 of the first surface of the semiconductor substrate 110 may have a consistent foreign substance doping concentration in the depth direction thereof. That is, no foreign substance may be diffused in the first surface of the semiconductor substrate 110 including the first conductive area 20, which may increase the reliability and efficiency of the solar cell 100.

However, the technical sprit of the present disclosure is not limited thereto, and in another implementation of the present disclosure, a semiconductor layer may be formed on one of the first and second edge areas EA1 and EA2 on the first surface of the semiconductor substrate 110. A detailed description will be provided later.

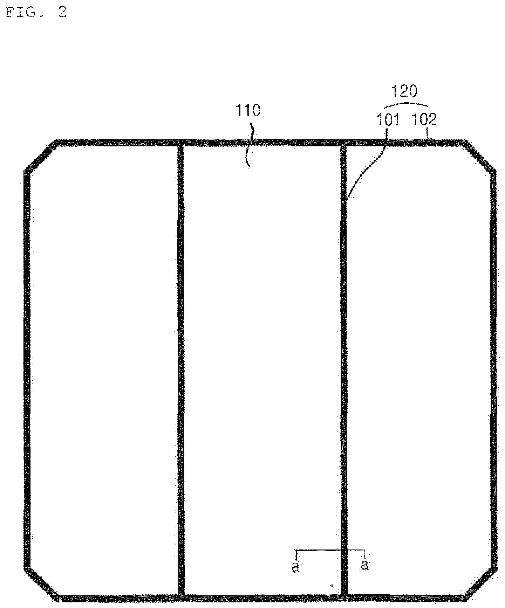

Next, a method of manufacturing the solar cell according to some implementations of the present disclosure will be described with reference to FIGS. 2 to 11.

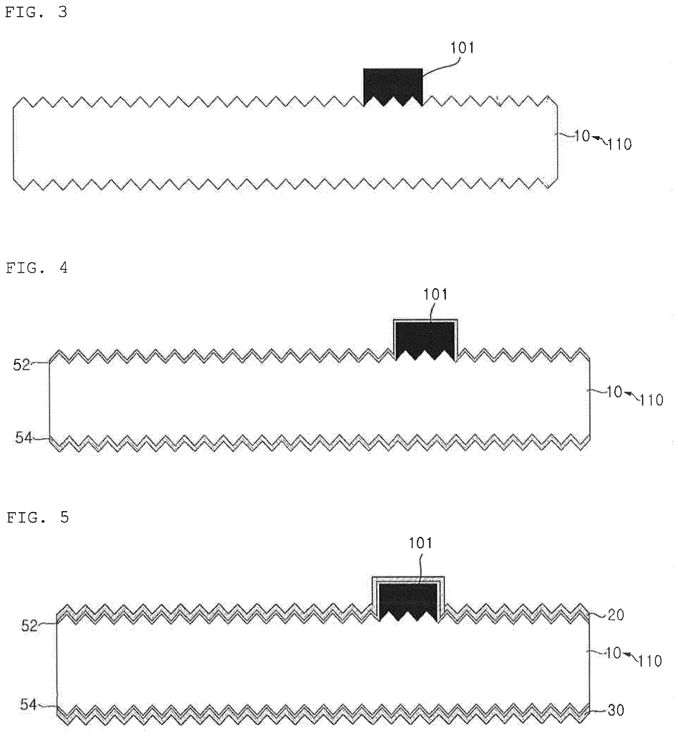

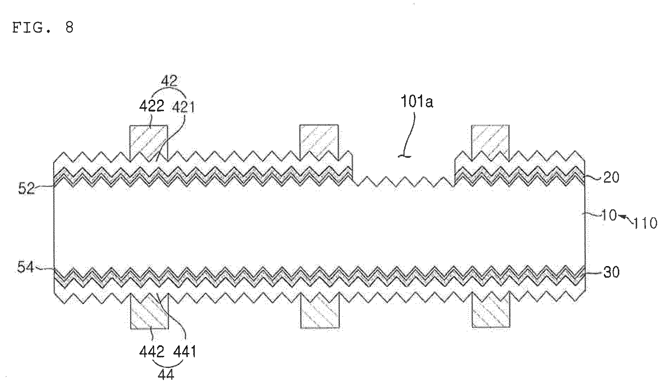

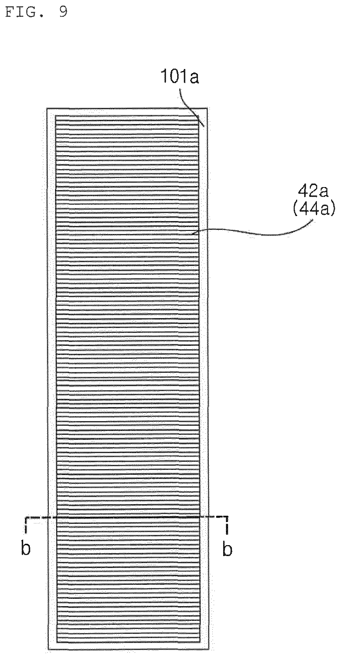

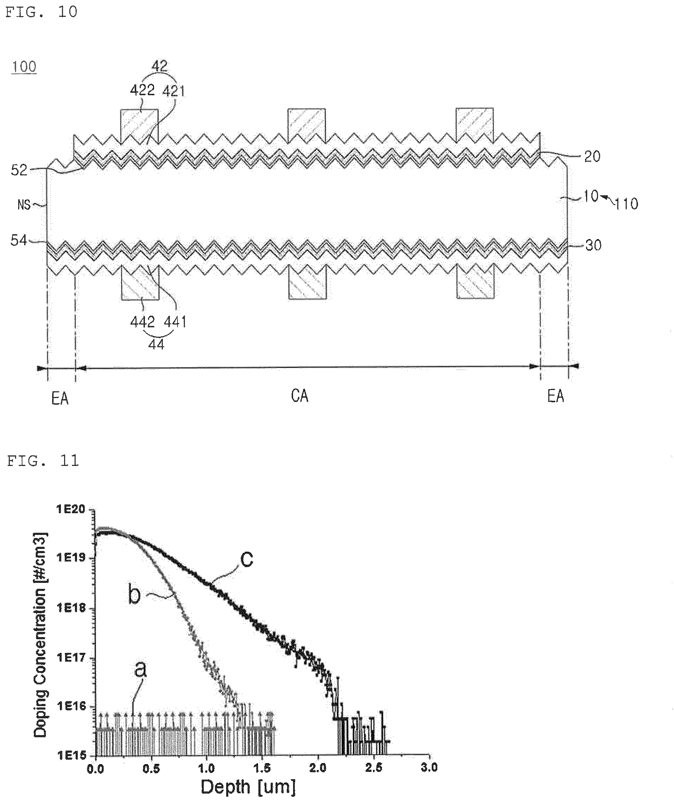

FIGS. 2 to 11 are cross-sectional views and plain views for explaining a method of manufacturing the solar cell according to some implementations of the present disclosure. FIG. 2 is a plain view for explaining the method of manufacturing the solar cell, and FIGS. 3 to 6 are cross-sectional views taken along line A-A of FIG. 2. FIG. 7 is a plain view for explaining the method of manufacturing the solar cell, and FIG. 8 is a cross-sectional view of FIG. 7 taken along the same direction as line A-A of FIG. 2. FIG. 9 is a plain view for explaining the method of manufacturing the solar cell, and FIG. 10 is a cross-sectional view taken along line a-b.

Referring to FIGS. 2 and 3, a mask 120 is disposed on the semiconductor substrate 110 including the base area 10. The mask 120 includes an edge portion 102 and a line portion 101. The edge portion 102 of the mask 120 may be disposed on the rim, i.e. an edge portion of the semiconductor substrate 110, and the line portion 101 may be disposed on the area of the semiconductor substrate 110 in which a scribing process will be performed later, i.e. a scribing portion of the semiconductor substrate 110.

In the present implementation, although the mask 120 is illustrated as including two line portions 101, the technical sprit of the present disclosure is not limited thereto. Thus, the mask 120 may include one line portion 101 or three or more line portions 101, and the number of line portions may be appropriately adjusted according to the number of portions into which the semiconductor substrate 110 will be divided.

The mask 120 may be formed of any of various materials having structural rigidity, for example, a curable polymer material. The constituent material of the mask 120 may not be particularly limited so long as it has rigidity required to separate a semiconductor layer that is disposed on the mask 120 from a semiconductor layer that is not disposed on the mask 120 in a following process.

Referring again to FIG. 3, the line portion 101 of the mask 120 may have a rectangular cross section. Although a semiconductor layer disposed on the mask 120 may be easily separated when the mask 120 has a rectangular cross section, the present disclosure is not limited thereto, and the mask 120 may have a polygonal cross section including a triangular cross section, or may have a circular cross section. In addition, the width of the line portion 101 may range from 4 mm to 10 mm, without being limited thereto.

Referring to FIG. 4, the first passivation layer 52 is formed on the first surface of the semiconductor substrate 110 and the line portion 101, and the second passivation layer 54 is formed on the second surface of the semiconductor substrate 110.

The first and second passivation layers 52 and 54 may be formed by, for example, thermal growth or deposition (e.g., chemical vapor deposition (PECVD) or atomic layer deposition (ALD)). However, the present disclosure is not limited thereto, and the first and second passivation layers 52 and 54 may be formed by various other methods. The first and second passivation layers 52 and 54 may be formed simultaneously or sequentially.

Subsequently, referring to FIG. 5, the first conductive area 20 and the second conductive area 30 are formed on the first and second passivation layers 52 and 54. More specifically, the first conductive area 20 is formed on the first passivation layer 52, and the second conductive area 30 is formed on the second passivation layer 54.

The first conductive area 20 and the second conductive area 30 may be formed by, for example, thermal growth or deposition (e.g., chemical vapor deposition (PECVD) or atomic layer deposition (ALD)). A first or second conductive dopant may be included in a process of growing a semiconductor layer including the first conductive area 20 and the second conductive area 30, or may be doped by, for example, ion implantation, thermal diffusion, or laser doping after the semiconductor layer is formed. However, the present disclosure is not limited thereto, and the first conductive area 20 and the second conductive area 30 may be formed by various other methods. The first conductive area 20 and the second conductive area 30 may be formed simultaneously, and then be doped, or may be deposited sequentially and/or doped.

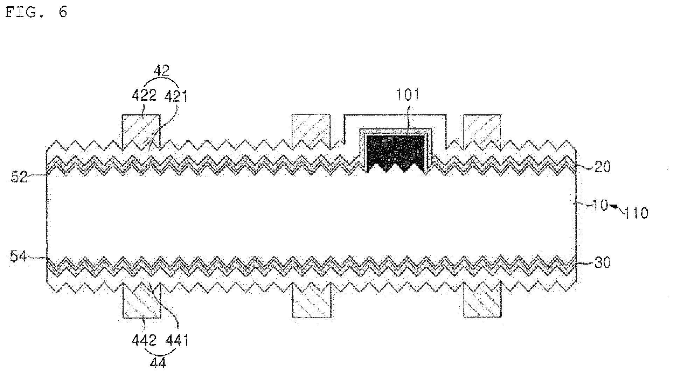

Subsequently, referring to FIG. 6, the first and second electrodes 42 and 44 are formed on the first conductive area 20 and the second conductive area 30. Specifically, the first and second transparent electrode layers 421 and 441 are formed on the first conductive area 20 and the second conductive area 30, and the first and second metal electrode layers 422 and 442 are formed on the first and second transparent electrode layers 421 and 441.

The first and second transparent electrode layers 421 and 441 may be formed by, for example, deposition (e.g., chemical vapor deposition (PECVD)) or coating. However, the present disclosure is not limited thereto, and the first and second transparent electrode layers 421 and 441 may be formed by various other methods.

In one example, the first and second transparent electrode layers 421 and 441 may be formed by introducing a raw material, which is a main constituent material, and a mixed gas of hydrogen gas (H₂) and carrier gas (e.g., argon gas (Ar) or nitrogen gas (N₂)). Thereby, hydrogen may be included in the first and second transparent electrode layers 421 and 441 so as to realize any relevant effect.

The first and second metal electrode layers 422 and 442 are formed on the first and second transparent electrode layers 421 and 441.

Subsequently, a first low-temperature paste layer is formed on one of the first conductive area 20 and the second conductive area 30 (more specifically, on the first and second transparent electrode layers 421 and 441), and is dried to form one of the first and second metal electrode layers 422 and 442. A second low-temperature paste layer is formed on the other one of the first conductive area 20 and the second conductive area 30, and is dried to form the other one of the first and second metal electrode layers 422 and 442. However, the present disclosure is not limited thereto, and the first and second low-temperature paste layers may be simultaneously formed on the opposite sides and then be simultaneously dried.

Subsequently, referring to FIGS. 7 and 8, the mask 120 is removed to expose the semiconductor substrate 110. When the mask 120 is removed, an exposed space 101a is formed. Since the portions of the first passivation layer 52, the first conductive area 20, and the first transparent electrode layer 421, which are disposed on the mask 102, are removed, simultaneously with the removal of the mask 102, the exposed space 101a is formed. The semiconductor substrate 110 is exposed through the exposed space 101a. A portion of the semiconductor substrate 110 corresponding to the exposed space 101a is a scribing portion of the semiconductor substrate 110.

First, the first and second metal electrode layers 421 and 441 will be described with reference to FIG. 7.

Referring to FIG. 7, the first and second metal electrode layers 422 and 442 may respectively include a plurality of finger lines 42a and 44a, which are spaced apart from one another at a constant pitch. Although FIG. 7 illustrates the finger lines 42a and 44a as being parallel to each other and also being parallel to the edge of the semiconductor substrate 110, the present disclosure is not limited thereto. In addition, the first and second metal electrode layers 422 and 442 may include bus-bars, which are formed to intersect the finger lines 42a and 44a so as to connect the finger lines 42a and 44a. One bus-bar may be provided, or a plurality of bus-bars may be provided at a larger pitch than the pitch of the finger lines 42a and 44a. Meanwhile, in the present implementation, for brief illustration, the bus-bar is not illustrated in FIG. 7.

Meanwhile, when the first metal electrode layer 422 is formed, it may not be formed in the exposed space 101a. That is, as illustrated in FIG. 6, the first metal electrode layer 422 is not formed on the mask 102. Thereby, it is possible to prevent the first metal electrode layer 422 from being excessively removed when the mask 102 is removed.

Meanwhile, in the present implementation, although the exposed space 101a is illustrated as being formed in the location at which it intersects the finger line 42a, the exposed space 101a may be formed to intersect the bus-bar when the first metal electrode layer 422 is formed. In this case, no bus-bar is formed on the mask 102.

Meanwhile, in the present implementation, although the sidewalls of the first passivation layer 52, the first conductive area 20, and the first transparent electrode layer 421, which are exposed through the exposed space 101a, are successively formed, the present disclosure is not limited thereto. Thus, the sidewalls of the first passivation layer 52, the first conductive area 20, and the first transparent electrode layer 421 may be discontinuously formed.

Meanwhile, referring again to FIG. 7, the semiconductor substrate 110 includes a first area I, a second area II, and a third area III. The first area I, the second area II, and the third area III may have the same area. That is, when the semiconductor substrate 110 is divided on the basis of the exposed space 101a, the divided first area I, second area II, and third area III of the semiconductor substrate 110 may have the same area.

Subsequently, referring to FIGS. 9 and 10, the semiconductor substrate 110 is divided on the basis of the exposed space 101a.

Specifically, a scribing process is performed by irradiating the exposed space 101a with a laser.

The scribing process may be performed via a laser device including a chuck table. The laser device includes a laser emitter, and the laser emitter may adjust, for example, the frequency, power, and pulse width of a laser beam. The laser device may emit a laser beam having a specific power and pulse width to the exposed space 101a in the semiconductor substrate 110 through a light collector. The laser device may include a separate alignment unit, and the alignment unit may perform positioning between the scribing portion including the exposed space 101a and the light collector of the laser device that emits the laser beam along the scribing portion.

In this way, the solar cell 100 illustrated in FIGS. 9 and 10 may be manufactured. The solar cell illustrated in FIG. 9 may correspond to the second area II of FIG. 7. The solar cell 100 includes the first and second edge areas EA1 and EA2 and the cell area CA, as described above with reference to FIG. 1. The first and second edge areas EA1 and EA2 correspond to the above-described exposed space 101a. Thus, since the first and second edge areas EA1 and EA2 undergo surface modification due to laser irradiation, the semiconductor substrate 110, which is exposed through the edge area EA on the first surface thereof, includes a laser-damaged area. Thus, the edge areas EA of the first surface and the second surface of the semiconductor substrate 110 may have different crystalline structures, and specifically, the first and second edge areas EA1 and EA2 of the first surface of the semiconductor substrate 110 may have a larger crystalline structure.

Meanwhile, although the cut semiconductor substrate 110 is illustrated in FIG. 9 as having a short horizontal side and a long vertical side, the technical sprit of the present disclosure is not limited thereto. That is, the cut semiconductor substrate 110 may of course have a long horizontal side and a short vertical side.

Meanwhile, in the present implementation where a laser is used in the scribing process, the laser is directly emitted to the semiconductor substrate 110. Thus, compared to a conventional case where a laser is emitted to the semiconductor substrate 110 having a semiconductor layer formed thereon, the semiconductor substrate 110 has a more uniform foreign substance doping concentration in the depth direction thereof.

FIG. 11 is a graph illustrating the doping concentration of the semiconductor substrate in the depth direction according to the present disclosure and the related art.

The line "a" shows the doping concentration of the semiconductor substrate 110 in the depth direction according to the present disclosure, and the lines "b" and "c" show the doping concentration of the semiconductor substrate 110 in the depth direction according to the related art. Here, the line "a" indicates the case where a laser having a power of 18W is emitted, the line "a" indicates the case where a laser having a power of 18W is emitted, and the line "c" indicates the case where a laser having a power of 25W is emitted.

Considering the line "a" according to the present disclosure with reference to FIG. 11, it can be seen that the semiconductor substrate 110 has uniform doping concentration in the depth direction thereof. Unlike this, in the related art, a semiconductor substrate is subjected to scribing when a laser is emitted to the semiconductor substrate having a semiconductor layer formed thereon. Thus, referring to the line "b" and the line "c" of the related art, it can be seen that the doping concentration varies in the depth direction. In addition, in the related art, since a foreign substance included in a conductive area diffuses to the semiconductor substrate via laser irradiation, it can be seen that the doping concentration is higher in the surface of the semiconductor substrate, compared to the present disclosure.

In the present disclosure, since laser irradiation for scribing the semiconductor substrate is directly performed on the semiconductor substrate 110 through the exposed space 101a, it is possible to prevent the foreign substance included in the conductive area from diffusing to the surface of the semiconductor substrate 110. In addition, compared to the conventional case where the laser is emitted to the semiconductor layer, it is possible to prevent the generation of foreign substances such as particles. Thereby, the solar cell manufactured according to the present implementation may achieve increased reliability and performance.

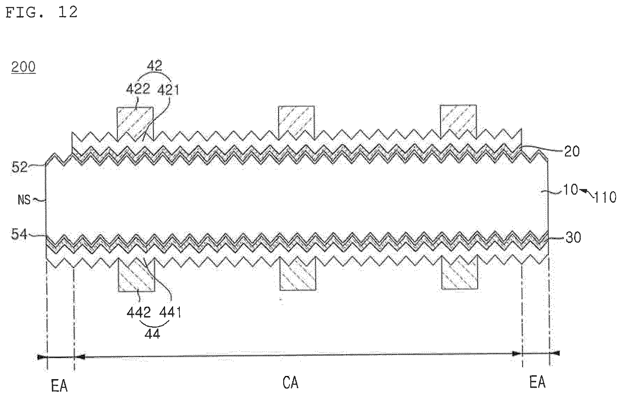

Next, a solar cell according to some implementations of the present disclosure will be described with reference to FIG. 12.

FIG. 12 is a cross-sectional view illustrating a solar cell according to some implementations of the present disclosure.

The solar cell of the present implementation is substantially the same as the solar cell described with reference to FIG. 1, except that the first passivation layer 52 is exposed through the edge area EA on the first surface of the semiconductor substrate 110. Thus, the same reference numerals designate the same elements, and a repeated description thereof will be omitted.

Referring to FIG. 12, the solar cell 200 according to the present implementation may include the semiconductor substrate 110 including the base area 10, the first passivation layer 52 formed on the first surface of the semiconductor substrate 110, the second passivation layer 54 formed on the second surface of the semiconductor substrate 110, the first conductive area 20 formed on the first passivation layer 52 at the first surface side of the semiconductor substrate 110, the second conductive area 30 formed on the second passivation layer 54 at the second surface side of the semiconductor substrate 110, the first electrode 42 electrically connected to the first conductive area 20, and the second electrode 44 electrically connected to the second conductive area 30.

In the present implementation, the first passivation layer 52 may be formed on the entire first surface of the semiconductor substrate 110. Thus, the passivation effect of the semiconductor substrate 110 may be improved.

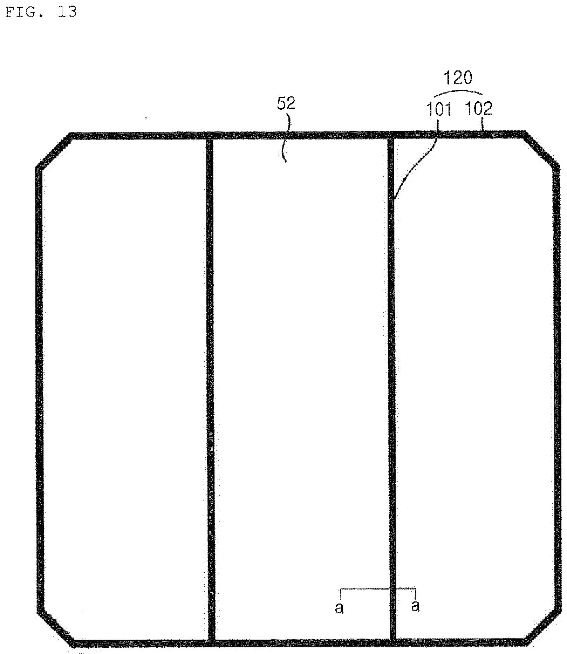

Next, a method of manufacturing the solar cell according to some implementations of the present disclosure will be described with reference to FIGS. 13 to 18.

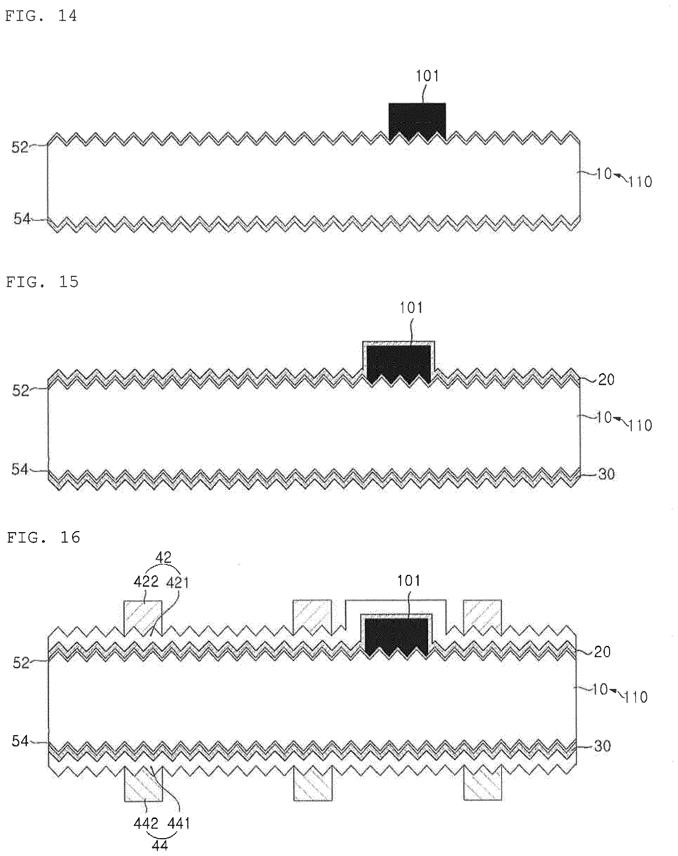

FIGS. 13 to 18 are cross-sectional views and plain views for explaining a method of manufacturing the solar cell according to some implementations of the present disclosure. FIG. 13 is a plain view illustrating an intermediate step of the solar cell manufacturing method, and FIG. 14 is a cross-sectional view taken along line a-a of FIG. 13.

The solar cell manufacturing method according to the present implementation is substantially the same as the solar cell manufacturing method described above with reference to FIGS. 2 to 11, except that the mask 120 is disposed on the first passivation layer 52. Thus, the same reference numerals designate the same elements, and a repeated description thereof will be omitted.

Referring to FIGS. 13 and 14, the mask 120 is disposed on the semiconductor substrate 110 having the first passivation layer 52 formed thereon.

Subsequently, referring to FIG. 15, the first conductive area 20 is formed on the first surface of the semiconductor substrate 110, and the second conductive area 30 is formed on the second surface. At this time, the first conductive area 20 may be directly formed on the upper surface and the sidewall of the line portion 101 of the mask 120.

Subsequently, referring to FIG. 16, the first electrode 42 is formed on the first conductive area 20, and the second electrode 44 is formed on the second conductive area 30.

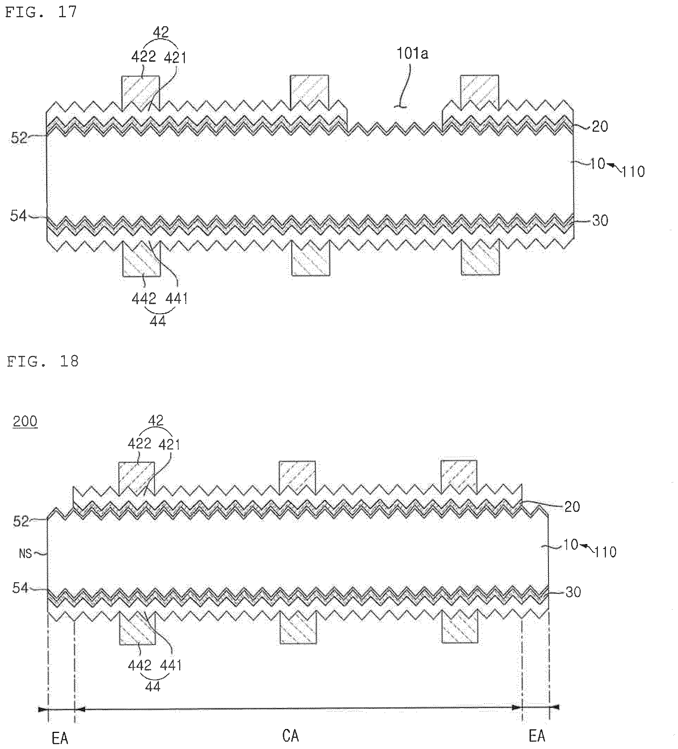

Subsequently, referring to FIG. 17, the line portion 101 of the mask 120 is removed to form the exposed space 101a that exposes the first passivation layer 52.

When the semiconductor substrate 110 may be separated along the exposed space 101a, the solar cell 200 may be formed as illustrated in FIG. 18.

Since the solar cell 200 according to the present implementation includes the first passivation layer 52 formed on the entire first surface of the semiconductor substrate 110, the passivation effect thereof may be more improved. The first passivation layer 52 includes an intrinsic semiconductor layer having no foreign substance. Thus, the solar cell 200 may have uniform foreign substance doping concentration in the depth direction of the semiconductor substrate 110, as illustrated in FIG. 11.

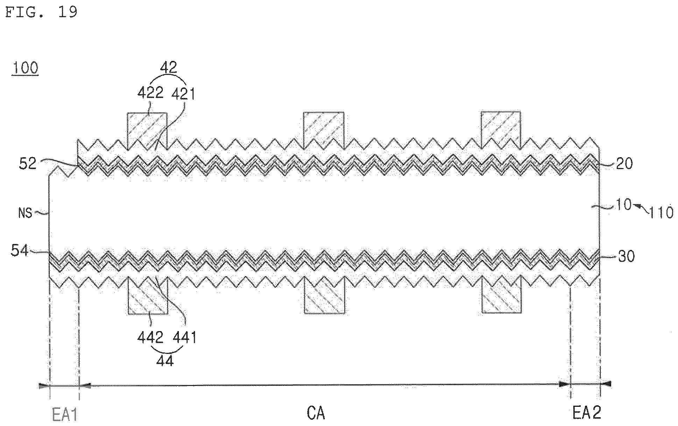

Next, a solar cell according to some implementations of the present disclosure will be described with reference to FIG. 19.

The solar cell of the present implementation is substantially the same as the solar cell described with reference to FIG. 1, except that the second edge area EA2 of the first surface is not exposed. Thus, a repeated description thereof will be omitted.

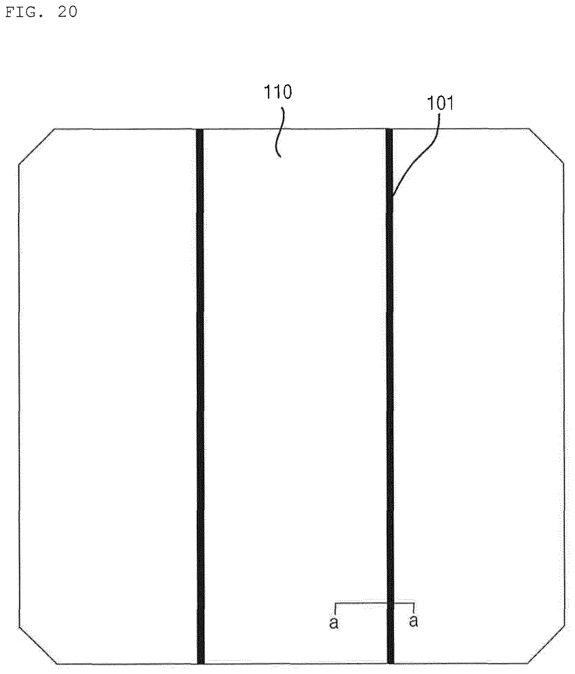

In the solar cell according to the present implementation, the second edge area EA2 of the first surface is not exposed. This configuration may be realized when the mask used in the solar cell manufacturing method includes no edge portion. This will be described in more detail with reference to FIGS. 20 to 23.

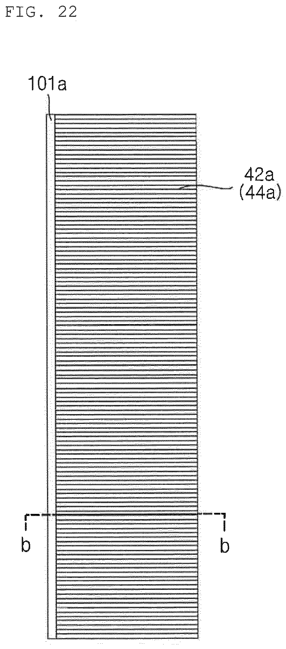

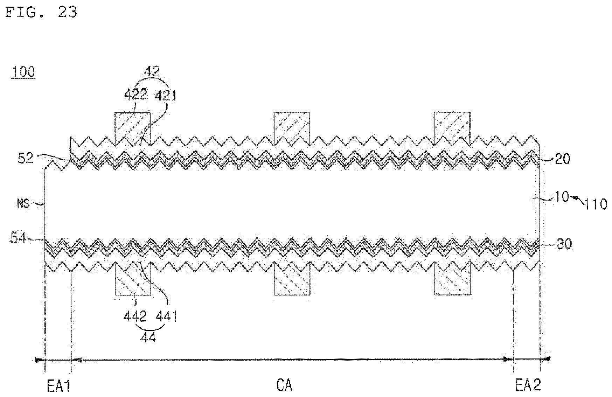

FIGS. 20 to 23 are cross-sectional views and plain views for explaining a method of manufacturing the solar cell according to some implementations of the present disclosure. FIG. 23 is a cross-sectional view taken along line b-b of FIG. 22.

The solar cell manufacturing method according to the present implementation is substantially the same as the solar cell manufacturing method described above with reference to FIGS. 2 to 11, except that the mask includes no edge portion. Thus, a repeated description thereof will be omitted, and the following description will be focused on only differences.

Referring to FIG. 20, the mask 101 according to the present implementation may be located so as to correspond to the scribing portion of the semiconductor substrate 110.

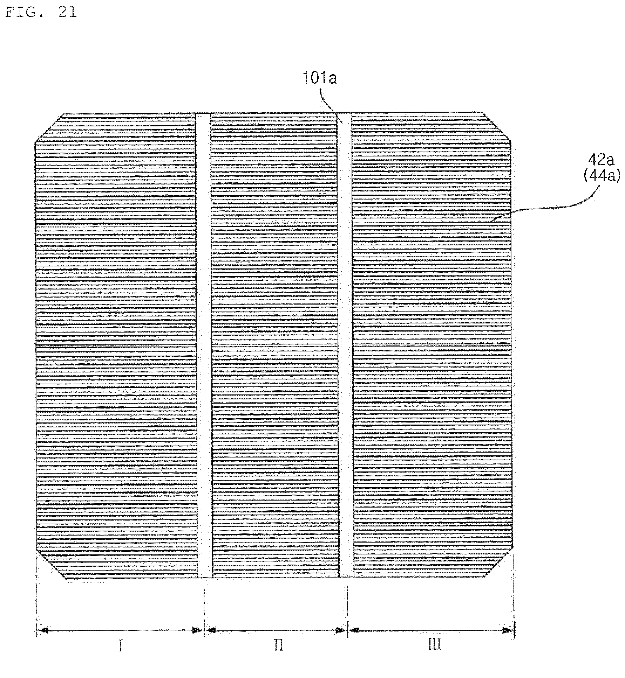

Thereby, referring to FIG. 21, the exposed space 101a, which exposes the semiconductor substrate 110, may be formed only in the semiconductor substrate 110, and may not be formed in any external portion that is adjacent to the side surface of the semiconductor substrate 110.

Accordingly, after the semiconductor substrate 110 is divided as illustrated in FIG. 21, referring to the solar cell of FIGS. 22 and 23, which corresponds to the third area III of FIG. 21, the first edge area EA1 of the solar cell 100 is exposed, whereas the second edge area EA2 is not exposed.

Meanwhile, solar cells manufactured via division of the semiconductor substrate 110 according to the present implementation may be electrically interconnected in series and/or in parallel via interconnectors, or may be interconnected so that specific areas thereof overlap each other. Thereby, the multiple solar cells may construct a solar cell panel.

## Claims

1. A method of manufacturing a solar cell (100), the method comprising:
preparing a monocrystalline silicon substrate (110) having a first surface and a second surface different from the first surface, wherein the monocrystalline silicon substrate (110) is divided into a plurality of cell portions including a first cell portion and a second cell portion, wherein a scribing portion is positioned between the first cell portion and the second cell portion;
disposing a mask (120) having a line portion (101) corresponding to the scribing portion on the first surface of the monocrystalline silicon substrate (110);
forming a first passivation layer (52) on the first surface of the monocrystalline silicon substrate (11) before disposing the mask (120) or after disposing the mask (120) on the first surface of the monocrystalline silicon substrate (110) and on the mask (120);
forming a first amorphous conductive silicon layer (20) on the first passivation layer (52) and the mask (120) on the first surface of the monocrystalline silicon substrate (110);
forming a second amorphous conductive silicon layer (30) entirely on a second passivation layer (54) on the second surface of the monocrystalline silicon substrate (110);
forming a first transparent electrode layer (421) on the first amorphous conductive silicon layer (20) and a first metal electrode layer (422) on the first transparent electrode layer (421) without forming the first metal electrode layer (422) on the scribing portion of the monocrystalline silicon substrate (110), and a second transparent electrode layer (441) on the second amorphous conductive silicon layer (30) and a second metal electrode layer (442) on the second transparent electrode layer (441),
entirely removing the mask (120) from the first surface of the monocrystalline silicon substrate (110) to remove a portion of the first amorphous conductive silicon layer (20), the first transparent electrode layer (421) and optionally the first passivation layer (52) that are disposed on the mask (120) to form a portion where the first amorphous conductive silicon layer (20) is not disposed; and
irradiating a laser along the scribing portion where the first amorphous conductive silicon layer (20), the first transparent electrode layer (421) and the first passivation layer (52) on the mask (120) are not disposed at the first surface to divide the monocrystalline silicon substrate (110) to form solar cells corresponding to each of the plurality of cell portions, respectively, after the removing of the mask (120),
wherein each solar cell of the solar cells has a first edge area (EA1), a second edge area (EA2), and a cell area (CA) between the first edge area (EA1) and the second edge area (EA2), and
wherein the first amorphous conductive silicon layer (20) is not disposed on the first edge area (EA1) at the first surface of the monocrystalline silicon substrate (110) of the solar cell.

2. The method of claim 1, wherein, in the disposing of the mask (120), the mask (120) further comprises an edge portion (102) disposed on an edge portion of the monocrystalline silicon substrate (110).

3. The method of claim 1, wherein, when forming the first passivation layer (52) after disposing the mask (120), the step of removing the mask (120) includes:
removing the mask (120) to expose the scribing portion of the monocrystalline silicon substrate (110) at the first surface of the monocrystalline silicon substrate (110).

4. The method of claim 1, wherein the scribing portion of the monocrystalline silicon substrate (110) has a uniform doping concentration in a depth direction of the monocrystalline silicon substrate (110) being substantially perpendicular to the first surface of the monocrystalline silicon substrate (110).

5. The method of any one of claims 1, 2 or 4,
wherein, in the step of forming the first passivation layer (52) on the first surface of the monocrystalline silicon substrate (110) before disposing the mask (120), the first passivation layer (52) is a first intrinsic amorphous silicon layer (52), and
wherein removing the mask (120) includes:
removing the mask (120) to expose a portion of the first intrinsic amorphous silicon layer (52) that is disposed on the scribing portion of the monocrystalline silicon substrate (110).

## Patentansprüche

1. Verfahren zum Herstellen einer Solarzelle (100), wobei das Verfahren umfasst:
Herstellen eines monokristallinen Siliciumsubstrats (110) mit einer ersten Oberfläche und einer zweiten Oberfläche, die sich von der ersten Oberfläche unterscheidet, wobei das monokristalline Siliciumsubstrat (110) in eine Vielzahl von Zellabschnitten unterteilt ist, die einen ersten Zellabschnitt und einen zweiten Zellabschnitt einschließen, wobei ein Ritzabschnitt zwischen dem ersten Zellabschnitt und dem zweiten Zellabschnitt positioniert ist;
Anordnen einer Maske (120) mit einem Leitungsabschnitt (101), der dem Ritzabschnitt auf der ersten Oberfläche des monokristallinen Siliciumsubstrats (110) entspricht;
Ausbilden einer ersten Passivierungsschicht (52) auf der ersten Oberfläche des monokristallinen Siliciumsubstrats (11) vor Anordnen der Maske (120) oder nach Anordnen der Maske (120) auf der ersten Oberfläche des monokristallinen Siliciumsubstrats (110) und auf der Maske (120);
Ausbilden einer ersten amorphen leitfähigen Siliciumschicht (20) auf der ersten Passivierungsschicht (52) und der Maske (120) auf der ersten Oberfläche des monokristallinen Siliciumsubstrats (110);
Ausbilden einer zweiten amorphen leitfähigen Siliciumschicht (30) vollständig auf einer zweiten Passivierungsschicht (54) auf der zweiten Oberfläche des monokristallinen Siliciumsubstrats (110);
Ausbilden einer ersten transparenten Elektrodenschicht (421) auf der ersten amorphen leitfähigen Siliciumschicht (20) und einer ersten Metallelektrodenschicht (422) auf der ersten transparenten Elektrodenschicht (421), ohne die erste Metallelektrodenschicht (422) auf dem Ritzabschnitt des monokristallinen Siliciumsubstrats (110) auszubilden, und einer zweiten transparenten Elektrodenschicht (441) auf der zweiten amorphen leitfähigen Siliciumschicht (30) und einer zweiten Metallelektrodenschicht (442) auf der zweiten transparenten Elektrodenschicht (441),
vollständiges Entfernen der Maske (120) von der ersten Oberfläche des monokristallinen Siliciumsubstrats (110), um einen Abschnitt der ersten amorphen leitfähigen Siliciumschicht (20), die erste transparente Elektrodenschicht (421) und optional die erste Passivierungsschicht (52), die auf der Maske (120) angeordnet sind, zu entfernen, um einen Abschnitt zu bilden, in dem die erste amorphe leitfähige Siliciumschicht (20) nicht angeordnet ist; und
Bestrahlen eines Lasers entlang des Ritzabschnitts, wobei die erste amorphe leitfähige Siliciumschicht (20), die erste transparente Elektrodenschicht (421) und die erste Passivierungsschicht (52) auf der Maske (120) nicht an der ersten Oberfläche angeordnet sind, um das monokristalline Siliciumsubstrat (110) zu teilen, um Solarzellen zu bilden, die jeweils jedem der Vielzahl von Zellabschnitten entsprechen, nach dem Entfernen der Maske (120),
wobei jede Solarzelle der Solarzellen einen ersten Randbereich (EA1), einen zweiten Randbereich (EA2) und einen Zellenbereich (CA) zwischen dem ersten Randbereich (EA1) und dem zweiten Randbereich (EA2) aufweist, und
wobei die erste amorphe leitfähige Siliciumschicht (20) nicht auf dem ersten Randbereich (EA1) an der ersten Oberfläche des monokristallinen Siliciumsubstrats (110) der Solarzelle angeordnet ist.

2. Verfahren nach Anspruch 1, wobei beim Anordnen der Maske (120) die Maske (120) ferner einen Randabschnitt (102) umfasst, der an einem Randabschnitt des monokristallinen Siliciumsubstrats (110) angeordnet ist.

3. Verfahren nach Anspruch 1, wobei, wenn die erste Passivierungsschicht (52) nach dem Anordnen der Maske (120) ausgebildet wird, der Schritt des Entfernens der Maske (120) einschließt:
Entfernen der Maske (120), um den Ritzabschnitt des monokristallinen Siliciumsubstrats (110) an der ersten Oberfläche des monokristallinen Siliciumsubstrats (110) freizulegen.

4. Verfahren nach Anspruch 1, wobei der Ritzabschnitt des monokristallinen Siliciumsubstrats (110) eine gleichmäßige Dotierungskonzentration in einer Tiefenrichtung des monokristallinen Siliciumsubstrats (110) aufweist, die im Wesentlichen senkrecht zu der ersten Oberfläche des monokristallinen Siliciumsubstrats (110) ist.

5. Verfahren nach einem der Ansprüche 1, 2 oder 4,
wobei im Schritt des Ausbildens der ersten Passivierungsschicht (52) auf der ersten Oberfläche des monokristallinen Siliciumsubstrats (110) vor dem Anordnen der Maske (120) die erste Passivierungsschicht (52) eine erste intrinsische amorphe Siliciumschicht (52) ist, und
wobei das Entfernen der Maske (120) einschließt:
Entfernen der Maske (120), um einen Abschnitt der ersten intrinsischen amorphen Siliciumschicht (52) freizulegen, die auf dem Ritzabschnitt des monokristallinen Siliciumsubstrats (110) angeordnet ist.

## Revendications

1. Procédé de fabrication d'une cellule solaire (100), comprenant :
la préparation d'un substrat de silicium monocristallin (110) ayant une première surface et une seconde surface différente de la première surface, dans lequel le substrat de silicium monocristallin (110) est divisé en une pluralité de portions de cellules comprenant une première portion de cellule et une seconde portion de cellule, dans lequel une portion de rainurage est positionnée entre la première portion de cellule et la seconde portion de cellule;
le dépôt sur la première surface du substrat de silicium monocristallin (110) d'un masque (120) ayant une portion de ligne (101) correspondant à la portion de rainurage;
la formation d'une première couche de passivation (52) sur la première surface du substrat de silicium monocristallin (110) avant de disposer le masque (120) ou après avoir disposé le masque (120) sur la première surface du substrat de silicium monocristallin (110) et sur le masque (120);
la formation d'une première couche de silicium conducteur amorphe (20) sur la première couche de passivation (52) et le masque (120) sur la première surface du substrat de silicium monocristallin (110);
la formation d'une seconde couche de silicium amorphe conducteur (30) entièrement sur une seconde couche de passivation (54) sur la seconde surface du substrat de silicium monocristallin (110) ;
la formation d'une première couche d'électrode transparente (421) sur la première couche de silicium conducteur amorphe (20) et une première couche d'électrode métallique (422) sur la première couche d'électrode transparente (421) sans former la première couche d'électrode métallique (422) sur la portion de rainurage du substrat de silicium monocristallin (110), et d'une deuxième couche d'électrode transparente (441) sur la deuxième couche de silicium conducteur amorphe (30) et une deuxième couche d'électrode métallique (442) sur la deuxième couche d'électrode transparente (441),
le retrait complet du masque (120) de la première surface du substrat de silicium monocristallin (110) pour enlever une partie de la première couche de silicium conducteur amorphe (20), de la première couche d'électrode transparente (421) et éventuellement de la première couche de passivation (52) qui sont disposées sur le masque (120) pour former une partie où la première couche de silicium conducteur amorphe (20) n'est pas disposée; et
l'irradiation d'un laser le long de la portion de rainurage où la première couche de silicium conducteur amorphe (20), la première couche d'électrode transparente (421) et la première couche de passivation (52) sur le masque (120) ne sont pas disposées sur la première surface pour diviser le substrat de silicium monocristallin (110) afin de former des cellules solaires correspondant à chacune de la pluralité de portions de cellules, respectivement, après l'enlèvement du masque (120),
dans laquelle chaque cellule solaire des cellules solaires a une première zone de bord (EA1), une deuxième zone de bord (EA2), et une zone de cellule (CA) entre la première zone de bord (EA1) et la deuxième zone de bord (EA2), et
dans laquelle la première couche de silicium conducteur amorphe (20) n'est pas disposée sur la première zone de bord (EA1) à la première surface du substrat de silicium monocristallin (110) de la cellule solaire.

2. Procédé selon la revendication 1, dans lequel, lors de la disposition du masque (120), le masque (120) comprend en outre une partie de bord (102) disposée sur une partie de bord du substrat de silicium monocristallin (110).

3. Procédé selon la revendication 1, dans lequel, lors de la formation de la première couche de passivation (52) après la pose du masque (120), l'étape de retrait du masque (120) comprend:
le retrait du masque (120) pour exposer la portion de rainurage du substrat de silicium monocristallin (110) sur la première surface du substrat de silicium monocristallin (110).

4. Procédé selon la revendication 1, dans lequel la portion de rainurage du substrat de silicium monocristallin (110) a une concentration de dopage uniforme dans une direction de profondeur du substrat de silicium monocristallin (110) étant sensiblement perpendiculaire à la première surface du substrat de silicium monocristallin (110).

5. Procédé selon l'une des revendications 1, 2 ou 4
dans lequel, dans l'étape de formation de la première couche de passivation (52) sur la première surface du substrat de silicium monocristallin (110) avant la pose du masque (120), la première couche de passivation (52) est une première couche de silicium amorphe intrinsèque (52), et
dans lequel le retrait du masque (120) comprend:
le retrait du masque (120) pour exposer une partie de la première couche de silicium amorphe intrinsèque (52) qui est disposée sur la portion de rainurage du substrat de silicium monocristallin (110) .
